# EUROPEAN PATENT SPECIFICATION

(11) **EP 3 254 539 B1**
(45) Date of publication and mention of the grant of the patent: **28.07.2021**
(21) Application number: 15705550.0
(22) Date of filing: 09.02.2015
(51) Int. Cl.: H05K 7/14

(54) **ASSEMBLY OF MODULES, MODULE SUPPORT AND MODULE**
ANORDNUNG AUS MODULEN, MODULTRÄGER UND MODUL
ENSEMBLE DE MODULES, SUPPORT DE MODULE ET MODULE

(30) Priority: 03.02.2015 US 201514613312
(43) Date of publication of application: 13.12.2017
(73) Proprietor: ALSTOM Technology Ltd, 5400 Baden (CH)
(72) Inventor: RAUBO, Roman, Downingtown, Pennsylvania 19335 (US); FURYK, Marek, Boyertown, Pennsylvania 19512 (US)
(74) Representative: Brevalex
(86) International application number: PCT/EP2015/052637
(87) International publication number: WO 2016/124254

(56) References cited:
- WO-A1-2014/087356
- US-A- 6 144 888
- US-A1- 2014 022 738

## Description

### TECHNICAL DOMAIN

The invention relates to the domain of the high voltage circuits such as voltage-source converters, and more precisely to the module support which support the modules that equip such high voltage circuits.

### PREVIOUS ART

A high voltage circuit, such as a voltage-source converter or a flexible alternative current transmission system, comprises usually many elements that can be arranged in modules. Such an element, or module, can comprise two complementary connectable sub-modules: an electrical device sub-module, such as including a direct current capacitor (also known as a DC capacitor), and a front end sub-module for the connection of the electrical device sub-module to the remaining of the high voltage circuit.

For example and for a voltage source-converter, such a module can be a full bridge/DC capacitor module in which the device is a DC capacitor and the front end sub-module is a full bridge sub-module with which it is possible to control, in use, the polarity of the connection between the DC capacitor and the remaining of the voltage source-converter. Usually, the complementary sub-modules that form a module are packed together in one package in a casing.

A high voltage circuit also comprises a module support, such as a stack frame, to support and connect all the modules. In this way, when the circuit is built, all the modules are placed on the module support each one, at a corresponding location on the module support, and are connected to the other modules to form the high voltage circuit.

With this configuration, a high voltage circuit is easily repairable thanks to the possibility to replace each module or sub-module by a new one. However, this configuration has some drawbacks as the installation is particularly difficult due to the weight of a module (around 150 kg) and to the height of the module support at which a module can be installed. Furthermore, even if it is necessary to change only one sub-module of a module it is required to remove the entire module from the module support.

It is also known from document US 2014/022738 a modular converter cabinet system comprising a plurality of converter cells, each cells comprising two complementary connectable units: a capacitor unit and a semiconductor unit. In this document, each cell is assembled before being installed in a support of the modular converter cabinet system.

It is also known from document US 6,144,888 modular system, such as computers and multimedia devices, comprising a plurality of modules stacked together. Such modular systems are clearly not adapted to be used for furnishing high voltage circuits.

### PRESENTATION OF THE INVENTION

The invention is aimed to resolve these drawbacks.

In this purpose, the invention relates to a module support according to claim 1. An assembly of modules including such module support makes easier the building of an electrical circuit such as a voltage-source converter or a FACTS, since for mounting the modules of the assembly on the module support it is possible to mount individually each sub-module and form the module directly on the module support. In this way, the technician just has to manipulate the weight of only one sub-module at the time when it is required to mount a module at height. Furthermore, such assembly facilitates also the maintenance of the electrical circuit by allowing the change of one of the sub-modules that form a module without requiring moving the complementary sub-module. The new sub-module just has to be mounted at the location of the defective one to obtain an operative module. Additional aspects are set out in the dependent claims 2-10.

### BRIEF DESCRIPTION OF THE DRAWINGS

The present invention will be better understood with the reading of the specification of a furnished embodiment which does not limit the scope of the invention. This specification refers to the annexed drawings in which:
- figure 1 shows a module support on which a first sub-module is mounted and a second one, complementary to the first one, is in a position intended to be mounted on the module support to form a module,
- figure 2 is a close view of the module support of figure 1 with the first and the second sub-module intended to be mounted on the module support.

Same or similar parts in the different drawings use the same numerical reference to make easier the passage from one drawing to another.

### DETAILED PRESENTATION OF PARTICULAR EMBODIMENTS

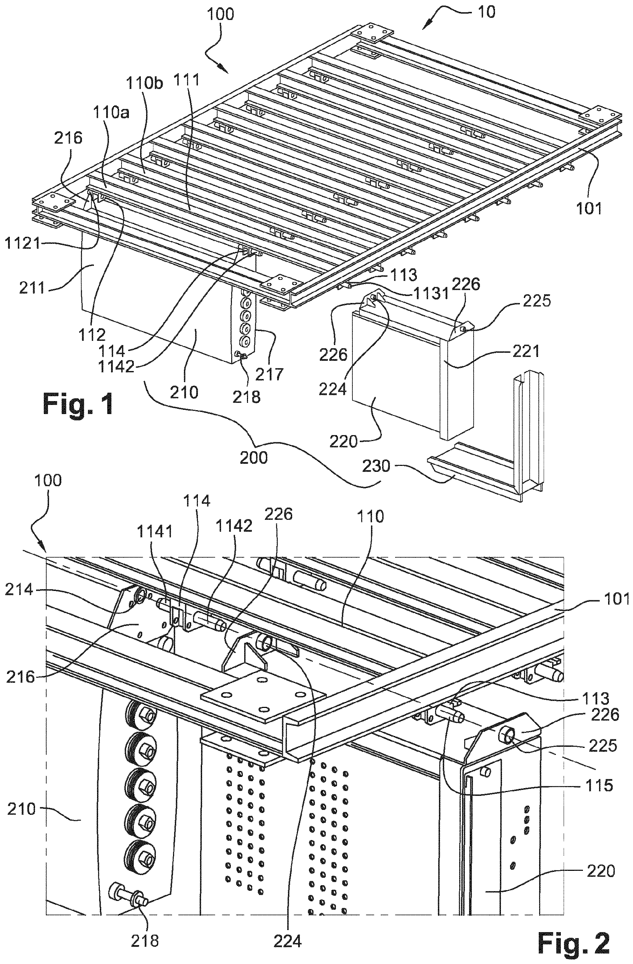

Figure 1 shows the module support 100 of the invention on which a sub-module, which is an electrical device sub-module 210, is mounted and a complementary sub-module, which is a front end sub-module 220, is in a position intended to be mounted on the module support 100 to form a module 200 when it will be connected on the electrical device sub-module 210.

The module support 100 illustrated on figure 1 has a generally rectangular shape and comprises a frame 101 and eight module locations 110a, 110b allocated along the length of the module support 100.

Each module location 110a, 110b comprises a support bar 111 that extends along the width of the module support 100. Each support bar 111 is provided with three extensions 112, 113, 114 with a first and a second extension each one on an extremity of the support bar 111 and a third one on a central part of the support bar 111. Each third extension 114 delimits together with corresponding first extension 112 a first portion of the corresponding support bar 111 that is intended to support an electrical device sub-module 210. Each third extension 114 delimits together with corresponding second extension 113 a second portion of the corresponding support bar 111 that is intended to support a front end sub-module 220.

Each extension 112, 113, 114 protrudes from the support bar 111 perpendicular to the plan of the module support 100 in such way that said extension 112, 113, 114 extends, when the module support 100 is mounted, in direction of the ground.

Each extension 112, 113, 114 comprises at least a rod 1121, 1131, 1141, 1142 that extends parallel to the corresponding support bar 111. More precisely, the first and second extensions 112, 113 comprise each one a rod whereas the third extensions comprise two rods.

The rod 1121 of each first extension 112 and one of the rods 1141, 1142 of the third extension 114 extend from the corresponding extension 112, 114 in a direction that goes from the second extension 113 to the first extension 112. The rod 1131 of the second extension 113 and the other rod 1142 of the third extension 114 extend from the corresponding extension 113, 114 in the direction that goes from the first extension 112 to the second extension 113

The rods 1121, 1131, 1141, 1142 allow the mounting of the sub-modules on the module support 100 to form the modules 200. The rods 1121, 1131, 1141, 1142 also form alignment members that are adapted to allow the alignment of sub-modules 210, 220 during their installation on the module support 100 in such way to connect them to complementary sub-modules 220, 210 already installed on the module support 100 to form the modules. Such alignment members are also adapted, as shown on figure 1, to support sub-modules by hang them.

To allow this cooperation between the rods of the module locations and the sub-modules, each sub-module comprises, as illustrated on figure 2, two holes 214, 224, 225.

The two sub-modules illustrated on figure 2, similarly to the ones of the previous art, are an electrical device sub-module 210 and a front end sub-module 220 to form together a module 200 when they are supported by the module support 100. Each sub-module 210, 220 differs from the one of the previous art by comprising an individual casing 211, 221, electrical connectors that are complementary than the ones of the other type of sub-modules and the holes 214, 224, 225 which are adapted to cooperate with the rods 1121, 1131, 1141, 1142 of a module location 110a, 110b of the module support 100.

A sub-module 210, 220, as illustrated on figure 2, presents, thanks to its casing, a generally rectangular cuboid shape with a longitudinal direction. On the top of the casing, each sub-module 210, 220 comprises two wings 216, 226.

The two wings 216, 226 of each sub-module extend upward parallel to each other from the top of the casing when the sub-module is mounted on the module support 100. The wings 216, 226 are planar and perpendicular to the longitudinal direction of the sub-module that comprises them. Each wing 216, 226 comprises one of the hole 214, 224, 225 of the corresponding sub-module 210, said hole 214, 224, 225 being a through hole.

Each sub-module 210, 220 also comprises electrical connectors 217, 218 to electrically connect the sub-module 210, 220, during its installation on the module support 100, to a complementary sub-module 220, 210 already installed on the module support 100. To furnish this connection, these electrical connectors 217, 218 are complementary to electrical connectors 217, 218 of the complementary sub-module 220, 210 to allow the connection by the mounting on the module support 100.

As shown on figures 1 and 2, the electrical device sub-module 210 comprises six female connectors 217 and one male connector 218 of the snap on type. In the same way, the front end sub-module comprises six male connectors and one female connector of the snap on type which are not show on the figure. The six male connectors and the one female connector of the front end sub-module 220 are arranged in such way they are facing a complementary connector 217, 218 of the electrical device sub-module 210 when both sub-modules 210, 220 are mounted on the module support 100 to form a module 200.

The module 200, shown on figure 1, also comprises an installation jig 230 for guiding the front end sub-module when it is mounted on the module support 100.

The module support 100 together with at least two modules form an assembly of modules 10.

Such assembly of modules 10 can be mounted by using a mounting method that comprises the following steps:
- furnishing the module support 100 and at least two electrical device sub-modules 210,
- mounting the electrical device sub-modules 210 on the first portion of the corresponding support bar 111 of the module support 100 by placing the electrical device sub-modules in such way to insert rods of the corresponding support bar 111 into the holes of the electrical device sub-modules 210,
- furnishing the same amount of front end sub-modules 220 than the electrical device sub-modules 210,
- mounting the front end sub-modules on the second portion of the corresponding support bar 111 on which an electrical device sub-modules 210 has already been mounted in such way to insert rods of the corresponding support bar 111 into the holes of the electrical device sub-modules and to connect the electrical connectors of the front end sub-modules with the ones of the corresponding electrical device sub-module 210.

With such configuration of the module assembly 10, all the sub-modules are perfectly aligned with a complementary sub-module. This alignment allows the connection of the electrical connectors of the sub-modules with the electrical connectors of the complementary sub-module and so the formation of the modules.

Such assembly of modules 10 can be used to at least partly form an electrical circuit such as an FACTS device as a source-voltage converter.

In another embodiment of the invention, not illustrated, the support bar 111 comprises holes on each extension 112, 113, 114 instead of the rods 1121, 1131, 1141, 1142 the sub-modules 210, 220 comprising on each wing 216, 226 a rod that is complementary than the holes of the corresponding support bar 111. Such holes could be passing through hole.

The invention does not limit to the use of alignment members which are rods 1121, 1131, 1141, 1142 or holes 214, 224, 225 but extend to the use of every type of alignment members which can be used to align a sub-module 210, 220 on a module support 100. For example, such alignment members can be rails or some lateral guides without extending beyond the scope of the invention, as defined by the appended set of claims.

## Claims

1. A module support (100) for an high voltage electrical circuit witch is a voltage source converter or a Flexible Alternative Current Transmission System, called FACTS,
which is for at least two modules (200), and that is adapted to support modules (200) which comprise two complementary connectable sub-modules (210, 220): an electrical device sub-module (210), such as including a direct current capacitor; and a front end sub-module (220) intented to connect in use the electrical device sub-module (210) to the remaining of the high voltage electrical circuit;
wherein the module support (100) is **characterized in that** it comprises for each module (200) it is intented to support:
- two alignment members each one adapted to individually align a sub-module (210, 220) during its installation on the module support (100) in such way to connect it to a complementary sub-module (220, 210) already installed on the module support (100) to form the module (200).

2. An assembly of modules (10) for an high voltage electrical circuit which is a voltage source converter or a Flexible Alternative Current Transmission System called FACTS, comprising :
- a module support (100) for at least two modules (200), the module support being a support according to claim 1,
- at least two modules (200), each module (200) comprising two complementary connectable sub-modules (210, 220): an electrical device sub-module (210), such as including a direct current capacitor; and a front end sub-module (220) intended to connect in use the electrical device sub-module to the remaining of the high voltage electrical circuit.

3. The assembly of modules (10) of claim 2, wherein the alignment member is also adapted to support the sub-module (210, 220) to align.

4. The assembly of modules (10) of claim 3, wherein the alignment means is adapted to hang the sub-module (210, 220) to align.

5. The assembly of modules (10) of claim 4, wherein each alignment member comprises a rod (1121, 1141, 1142, 1151), each sub-module (210, 220) comprising a complementary hole (214, 224, 225) to the rod (1121, 1141, 1142, 1151) of the corresponding alignment member so to hang it on the module support (100) when installed on the module support (100).

6. The assembly of modules (10) of claim 5, wherein for a module (200), the module support (100) comprises at least two rods (1121, 1141, 1142, 1151), one for each sub-modules (210, 220) of the module (200), which are extended in opposite directions from each other.

7. The assembly of modules (10) of claim 4, wherein each alignment member comprises at least a hole, each sub-module (210, 220) comprising a complementary rod to the hole of the corresponding alignment member so to hang it on the module support (100) when installed on the module support (100).

8. The assembly of modules (10) of any one from claims 2 to 7, wherein each sub-module comprises at least an electrical connector complementary to the electrical connector of the complementary sub-module to electrically connect them together during the alignment on the module support (100).

9. The assembly of modules (100) of any one from claims 2 to 8, wherein each module (200) comprises an installation jig (230) for guiding the front end sub-module (220) when it is mounted on the module support (100).

10. A Flexible Alternative Current Transmission System that comprises the assembly of modules according to any one of claims 2 to 9.

## Patentansprüche

1. Modulträger (100) für einen elektrischen Hochspannungsschaltkreis, der ein spannungsgeführter Umrichter oder ein flexibles Drehstromübertragungssystem, genannt FACTS, ist
das für mindestens zwei Module (200) ist, und das angepasst ist, um Module (200) zu tragen, die zwei komplementäre, verbindbare Untermodule (210, 220) umfassen: ein Elektrovorrichtung-Untermodul (210), wie einschließlich einen Gleichstromkondensator; und ein Vorderseitenende-Untermodul (220), vorgesehen, um bei Verwendung das Elektrovorrichtung-Untermodul (210) mit dem Rest des elektrischen Hochspannungsschaltkreises zu verbinden;
wobei der Modulträger (100) **dadurch gekennzeichnet ist, dass** er für jedes Modul (200), das zu tragen er vorgesehen ist, umfasst:
- zwei Ausrichtungselemente, jedes einzelne angepasst, um individuell ein Untermodul (210, 220) während seiner Montage an dem Modulträger (100) derart auszurichten, um es mit einem bereits an dem Modulträger (100) montierten komplementären Untermodul (220, 210) zu verbinden, um das Modul (200) zu bilden.

2. Modulzusammenbau (10) für einen elektrischen Hochspannungsschaltkreis, der ein spannungsgeführter Umrichter oder ein flexibles Drehstromübertragungssystem, genannt FACTS, ist, umfassend
- einen Modulträger (100) für mindestens zwei Module (200), wobei der Modulträger ein Träger nach Anspruch 1 ist,
- mindestens zwei Module (200), wobei jedes Module (200) zwei komplementäre verbindbare Untermodule (210, 220) umfasst: ein Elektrovorrichtung-Untermodul (210), wie einschließlich einen Gleichstromkondensator; und ein Vorderseitenende-Untermodul (220), vorgesehen, um bei Verwendung das Elektrovorrichtung-Untermodul mit dem Rest des elektrischen Hochspannungsschaltkreises zu verbinden.

3. Modulzusammenbau (10) nach Anspruch 2, wobei das Ausrichtungselement auch angepasst ist, um das auszurichtende Untermodul (210, 220) zu tragen.

4. Modulzusammenbau (10) nach Anspruch 3, wobei das Ausrichtungsmittel angepasst ist, um das auszurichtende Untermodul (210, 220) aufzuhängen.

5. Modulzusammenbau (10) nach Anspruch 4, wobei jedes Ausrichtungselement eine Stange (1121, 1141, 1142, 1151) umfasst, jedes Untermodul (210, 220) ein komplementäres Loch (214, 224, 225) zu der Stange (1121, 1141, 1142, 1151) des entsprechenden Ausrichtungselements umfasst, um es an dem Modulträger (100) aufzuhängen, wenn es an dem Modulträger (100) montiert wird.

6. Modulzusammenbau (10) nach Anspruch 5, wobei der Modulträger (100) für ein Modul (200) mindestens zwei Stangen (1121, 1141, 1142, 1151) umfasst, eine für jedes Untermodul (210, 220) des Moduls (200), die in entgegengesetzte Richtungen voneinander verlängert sind.

7. Modulzusammenbau (10) nach Anspruch 4, wobei jedes Ausrichtungselement mindestens ein Loch umfasst, jedes Untermodul (210, 220) eine komplementäre Stange zu dem Loch des entsprechenden Ausrichtungselements umfasst, um es an dem Modulträger (100) aufzuhängen, wenn es an dem Modulträger (100) montiert wird.

8. Modulzusammenbau (10) nach einem der Ansprüche 2 bis 7, wobei jedes Untermodul mindestens ein elektrisches Verbindungsstück, komplementär zu dem elektrischen Verbindungsstück des komplementären Untermoduls, umfasst, um diese während der Ausrichtung an dem Modulträger (100) elektrisch zusammen zu verbinden.

9. Modulzusammenbau (100) nach einem der Ansprüche 2 bis 8, wobei jedes Modul (200) eine Montagelehre (230) zum Führen des Vorderseitenende-Untermoduls (220), wenn es an dem Modulträger (100) angebracht wird, umfasst.

10. Flexibles Drehstromübertragungssystem, das den Modulzusammenbau nach einem der Ansprüche 2 bis 9 umfasst.

## Revendications

1. Support de module (100) pour un circuit électrique haute tension qui est un convertisseur de source de tension ou un système de transmission flexible en courant alternatif, nommé FACTS,
qui est pour au moins deux modules (200), et qui est adapté pour supporter des modules (200) qui comprennent deux sous-modules pouvant être raccordés de façon complémentaire (210, 220) : un sous-module de dispositif électrique (210), tel qu'incluant un condensateur de courant continu ; et un sous-module d'extrémité avant (220) destiné à raccorder lors de l'utilisation le sous-module de dispositif électrique (210) au reste du circuit électrique haute tension ;
dans lequel le support de module (100) est **caractérisé en ce qu'**il comprend pour chaque module (200) qu'il est destiné à supporter ;
- deux éléments d'alignement adaptés chacun de façon à aligner individuellement un sous-module (210, 220) pendant son installation sur le support de module (100) de façon à le raccorder à un sous-module complémentaire (220, 210) déjà installé sur le support de module (100) pour former le module (200).

2. Ensemble de modules (10) pour un circuit électrique haute tension qui est un convertisseur de source de tension ou un système de transmission flexible en courant alternatif nommé FACTS, comprenant :
- un support de module (100) pour au moins deux modules (200), le support de module étant un support selon la revendication 1,
- au moins deux modules (200), chaque module (200) comprenant deux sous-modules pouvant être raccordés de façon complémentaire (210, 220) : un sous-module de dispositif électrique (210) tel qu'incluant un condensateur de courant continu ; et un sous-module d'extrémité avant (220) destiné à raccorder lors de l'utilisation le sous-module de dispositif électrique au reste du circuit électrique haute tension.

3. Ensemble de modules (10) selon la revendication 2, dans lequel l'élément d'alignement est également adapté pour supporter le sous-module (210, 220) pour alignement.

4. Ensemble de modules (10) selon la revendication 3, dans lequel le moyen d'alignement est adapté pour suspendre le sous-module (210, 220) pour alignement.

5. Ensemble de modules (10) selon la revendication 4, dans lequel chaque élément d'alignement comprend une tige (1121, 1141, 1142, 1151), chaque sous-module (210, 220) comprenant un alésage complémentaire (214, 224, 225) à la tige (1121, 1141, 1142, 1151) de l'élément d'alignement correspondant de façon à le suspendre sur le support de module (100) lorsqu'il est installé sur le support de module (100).

6. Ensemble de modules (10) selon la revendication 5, dans lequel pour un module (200), le support de module (100) comprend au moins deux tiges (1121, 1141, 1142, 1151), une pour chaque sous-module (210, 220) du module (200), qui sont étendues dans des directions opposées l'une de l'autre.

7. Ensemble de modules (10) selon la revendication 4, dans lequel chaque élément d'alignement comprend au moins un alésage, chaque sous-module (210, 220) comprenant une tige complémentaire à l'alésage de l'élément d'alignement correspondant de façon à le suspendre sur le support de module (100) lorsqu'il est installé sur le support de module (100).

8. Ensemble de modules (10) selon l'une quelconque des revendications 2 à 7, dans lequel chaque sous-module comprend au moins un raccord électrique complémentaire au raccord électrique du sous-module complémentaire pour les raccorder électriquement conjointement pendant l'alignement sur le support de module (100).

9. Ensemble de modules (100) selon l'une quelconque des revendications 2 à 8, dans lequel chaque module (200) comprend un gabarit d'installation (230) pour guider le sous-module d'extrémité avant (220) lorsqu'il est monté sur le support de module (100).

10. Système de transmission flexible en courant alternatif qui comprend l'ensemble de modules selon l'une quelconque des revendications 2 à 9.
